# EUROPEAN PATENT APPLICATION

(11) **EP 4 741 923 A1**
(43) Date of publication of application: **13.05.2026**
(21) Application number: 24212323.0
(22) Date of filing: 12.11.2024
(51) Int. Cl.: G03F 7/00, F28D 15/02, G02B 7/00, H05G 2/00

(54) **RADIATION SOURCE, EUV UTILIZATION APPARATUS, AND METHOD**

(71) Applicant: ASML Netherlands B.V., 5500 AH Veldhoven (NL)
(72) Inventor: JANSSEN, Toni, Wil, Mathijs, 5500AH Veldhoven (NL)
(74) Representative: ASML Netherlands B.V.

(57) **Abstract**

There is provided a radiation source comprising a laser system, wherein the laser system is arranged to transport a laser beam from a source to a target region along a beam path, the beam path including at least one optical element in thermal communication with a vapour chamber arranged to distribute thermal energy provided by the laser beam and to cool the optical element in combination with a heat sink. Also provided is an EUV utilization apparatus including the radiation as well as a method of operating the radiation. Also described is the use of such a radiation source, EUV utilization apparatus or method in an EUV utilization method or apparatus.

## Description

### FIELD

The present invention relates to a radiation source. The radiation may have particular, but not exclusive, relevance to an EUV utilization apparatus, such as a lithographic apparatus or a metrology apparatus. The present invention also therefore relates to an EUV utilization apparatus, such as a lithographic apparatus or a metrology apparatus. In addition, the present invention relates to a method of operating a radiation source as well as the use of such a source, apparatus or method in an EUV utilization method or apparatus. The present invention has particular, but not exclusive application, to a drive laser of an EUV utilization apparatus.

### BACKGROUND

Light generated by means of a radiation source can be used by exposure apparatuses for semiconductor manufacturing processes. Examples of such exposure apparatuses are a lithographic apparatus, a metrology, or an inspection apparatus, such as a mask inspection apparatus or an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV radiation may be produced by a laser produced plasma (LPP) radiation source. Within an LPP radiation source, a laser beam may be used to irradiate fuel droplets so as to produce a plasma which will emit EUV radiation. The laser beam may be provided from a radiation source, such as a carbon dioxide laser. A problem associated with existing radiation sources is that optical elements within the radiation sources are exposed to high-powered laser light, which causes the optical elements to heat up. Such heating can cause deformation or damage to the optical elements, and so it is necessary to provide cooling to the optical elements. The requirement to provide cooling to the optical elements requires the addition of additional cooling lines and associated cooling equipment

It may be desirable to provide a radiation source in which optical elements are cooled more efficiently and more simply that disclosed or suggested by the prior art.

### SUMMARY

According to a first aspect of the invention, there is provided a radiation source comprising a laser system, wherein the laser system is arranged to transport a laser beam from a source to a target region along a beam path, the beam path including at least one optical element in thermal communication with a vapour chamber arranged to distribute thermal energy provided by the laser beam and to cool the optical element in combination with a heat sink.

In a radiation source, a laser beam is transported along a beam path via optical elements. Although the optical elements are configured to reduce the amount of energy absorbed from the laser beam, it is inevitable that when the laser beam illuminates the optical element some energy is absorbed causing the optical element to heat up. Heating up of the optical element can cause deformation or even damage to the optical element and so cooling is utilized to control the temperature of the optical element. In existing cooling systems, the cooling is effected by either direct cooling or indirect cooling. In direct cooling, there are channels, passages, pipes, or similar through which a cooling fluid, such as water, is passed and which thereby cools an optical element comprising the cooling channels, passages, pipes or similar. Examples of such direct cooled optical elements include mirrors of a beam transport system and final focus assembly. The cooling fluid thereby directly cools a slab under the optical element. As such, the cooling channels are integrated into the optical element. In indirect cooling, the cooling fluid, such as water, is used to cool an optical element holder rather than the optical element itself, and heat is transferred through the optical element to the optical element holder. Since the optical elements are generally made of copper and the optical elements are generally made of a different material, such as aluminium, there are two separate cooling fluid circuits, each requiring its own pipework, control mechanism, and cooling units. By providing an optical element with a vapour chamber arranged to distribute thermal energy provided by the laser beam and to cool the optical element in combination with a heat sink, the vapour chamber can act in the same way as a heat pipe whereby the rate at which heat can be transferred is greatly increased relative to the rate at which heat can transfer through a solid material. The vapour chamber serves to act as a heat spreader to more evenly distribute thermal energy across the optical element, thereby reducing or preventing hot spots that lead to unwanted deformation. With existing directly or indirectly cooled optical elements, there is still the possibility of hot spots being formed during use as there are no additional means to assist with heat spreading. With the vapour chamber in combination with a heat sink, the thermal energy provided by the laser can be rapidly distributed over the optical element to prevent hot spots and also the thermal energy can be removed via the heat sink. In this way, it is possible to simplify the cooling system and also reduce the cost of the cooling system, and reduce or effectively eliminate hot spots. In particular, if an optical element which is usually directly cooled is cooled by a vapour chamber, the production cost of such an optical element is much lower, such as an order of magnitude lower.

The optical element may comprise a reflective surface configured to reflect incident laser light. The reflective surface may comprises a wall of the vapour chamber. The vapour chamber may further comprise a heat sink and a fluid, the chamber being configured to transfer thermal energy from the reflective surface to the heat sink via the fluid. As such, the optical element may be a mirror. The optical element may comprise copper. The reflective surface may be a copper reflective surface. The reflective surface may include a coating configured to reflect incident carbon dioxide laser light. It will be appreciated that the reflective surface may comprise a copper layer on a support layer, or may consist of copper or a copper alloy. The optical element may be configured to reflect infrared light, such as light generated by a carbon dioxide laser. Copper is particularly useful in reflecting IR radiation given its high reflectivity of radiation in the IR region. In use, laser radiation illuminates the optical element causing the optical element to heat up. Heat is transferred to fluid within the vapour chamber, causing the fluid to heat up and to move within the vapour chamber. The heat sink is configured to remove thermal energy from the fluid within the vapour chamber, which causes the fluid to condense and flow back to the reflective surface where the process can continue. The vapour chamber not only serves to efficiently transfer thermal energy to the heat sink for cooling purposes, but also serves to spread out the heat to reduce or eliminate hot spots.

The heat sink may be an actively cooled heat sink. The heat sink may be a passively cooled heat sink. By actively cooled, it is understood that energy is input to result in cooling, such as in a refrigeration system. By passively cooled, it is understood that no energy input is provided and the cooling may be effected by passive transmission to the atmosphere. In view of the magnitude of cooling requirements in use, active cooling is preferred.

The optical element may be directly cooled. The optical element may be indirectly cooled. As mentioned, direct cooling is where the cooling is integrated into the component being cooled and indirect cooling is where the component being cooled is mounted on a support which is itself cooled. In view of the high cost associated with directly cooled optical elements, the present disclosure preferably allows for the replacement of at least one directly cooled optical element.

The laser system may be a carbon dioxide laser system. Carbon dioxide lasers are known. Carbon dioxide lasers are gas lasers which are able to generate continuous laser output of infrared radiation.

The radiation source may include at least two optical elements. A first optical element may be a beam transport system mirror or a final focus assembly mirror. The second optical element may be a high power drive laser mirror. The first and second mirrors may be cooled by respective heat sinks in thermal communication with a common conditioning fluid. As mentioned, within a radiation source there are usually two categories of mirror, namely directly cooled mirrors and indirectly cooled mirrors. Directly cooled mirrors, such as those used for the beam transport system or the final focus assembly, are used where better constrainment of aberrations is required than is provided by indirectly cooled mirrors. However, such mirrors are around an order of magnitude more expensive than indirectly cooled mirrors. Due to the presence of two different types of mirror, there are different cooling systems required. As such, each cooling system has a different pipework, control system, such as valves, and cooling apparatus to cool the cooling liquid. By providing an optical element in thermal communication with a vapour chamber, it is possible to have the different types of mirror on the same cooling circuit. This has the advantage of simplifying the cooling circuit since one set of pipework, control systems and cooling apparatus can be avoided.

The common conditioning fluid may comprise water. Additional compounds may be included in the water as is known in the art.

The optical element may be a mirror or an aperture. An aperture is a structure which includes a hold through which a laser beam passes in nominal use. Although apertures nominally allow a laser beam to pass through, there may be cases where the laser beam is misaligned and therefore illuminates a part of the aperture, or the aperture may be configured to intentionally be partially illuminated in nominal use.

According to a second aspect of the present disclosure, there is provided an EUV utilization apparatus including the radiation source according to the first aspect of the present disclosure.

The EUV utilization apparatus may be a lithographic apparatus, an inspection apparatus, or a metrology apparatus.

According to a third aspect of the present disclosure, there is provided a method of operating a radiation source, the method including: i) generating a laser beam; ii) illuminating an optical element with the laser beam, the optical element configured to reflect the laser beam; iii) providing a vapour chamber comprising a first face configured to reflect the laser beam and a second face configured to cool vapour within the chamber; iv) providing a conditioning fluid to the vapour chamber to condition vapour therein and consequently condition the optical element.

As described in relation to the first aspect of the present disclosure, the vapour chamber allows for heat to be removed from an optical element very efficiently and does away with the need for direct cooling of optical elements. In addition, the vapour chamber serves to more effectively spread heat across the optical element, thereby reducing or eliminating temperature differentials, which cause unwanted warping or deformation.

The method may include providing the conditioning fluid to the vapour chamber and to another optical element. As discussed, the presence of the vapour chamber allows for a single supply of conditioning fluid. Previously, where there were directly and indirectly cooled optical elements, two different supplies of conditioning fluid were required, which also required the associated pipework, control systems and separate coolers. As such, the present disclosure provides for a cheaper and simpler cooling system for a radiation source which has not previously been realized.

According to a fourth aspect of the present disclosure, there is provided the use of a radiation source according to the first aspect of the present disclosure, an EUV utilization apparatus according to the second aspect, or a method according to the third aspect in an EUV utilization method or apparatus.

The EUV utilization method or apparatus may be a lithographic apparatus or method, an inspection apparatus or method, or a metrology apparatus or method.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and further comprising a radiation source according to an embodiment of the invention;
- Figure 2 schematically depicts a system for (actinic) mask inspection which comprises a radiation source according to an embodiment of the invention;
- Figure 3 schematically depicts a radiation source according to an embodiment of the invention;
- Figures 4a and 4b are models comparing a copper mirror without a vapour chamber and a copper mirror comprising a vapour chamber; and
- Figure 5 is another version of Figure 4b with a narrower temperature scale demonstrating the small temperature differences across the copper mirror.

### DETAILED DESCRIPTION

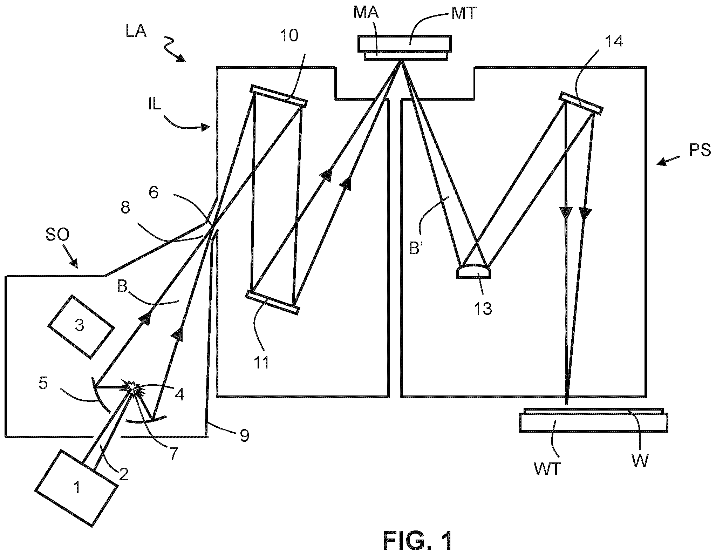

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a faceted field mirror device 10 and a faceted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

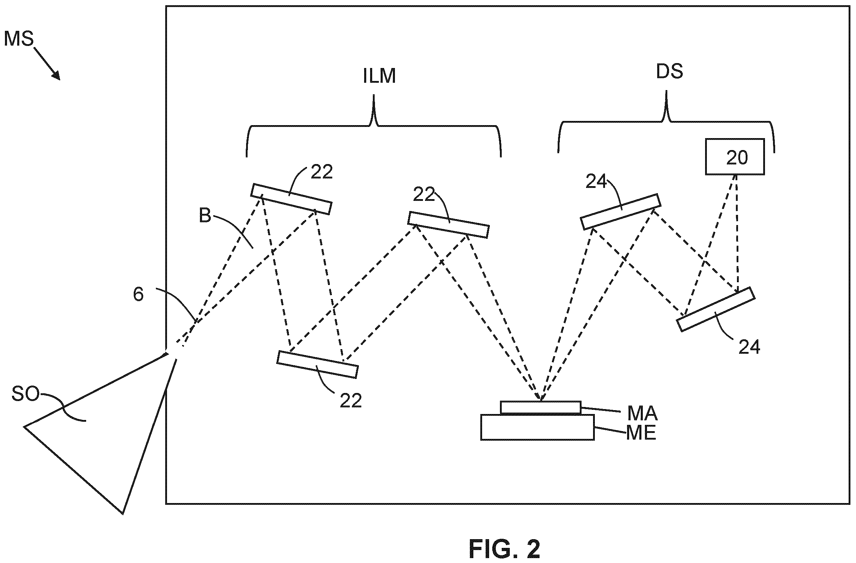

Figure 2 schematically depicts a system MS for (actinic) mask inspection. The mask inspection system MS can be used to identify or inspect defects in a mask to be used in a lithographic process by means of the lithographic apparatus described in figure 1. The mask inspection system MS comprises a radiation source SO, an illumination system ILM, a detection system DS and a mask stage ME. The radiation source SO is a radiation source according to the present disclosure.

The illumination system ILM is configured to condition an EUV radiation beam B before the EUV radiation beam B is incident upon the mask MA. The illumination system ILM may provide the EUV radiation beam B with a desired cross-sectional shape and a desired intensity distribution. The illumination system ILM may comprise a plurality of mirrors 22. The illumination system ILM may comprise one or more faceted mirror devices.

The mask stage ME may be configured to move the mask MA relative to the EUV radiation beam B, so that the EUV radiation beam is incident upon different areas of the mask.

The detection system DS comprises a detector 20, and may in addition comprise a plurality of mirrors 24. The plurality of mirrors 24 may be configured to collect EUV radiation BR that has been reflected from the mask MA, and form an image of the mask MA on the detector 20 (which may be an imaging array). A processor (not depicted) may receive signals output from the detector 20 and use those signals to look for defects in the mask MA.

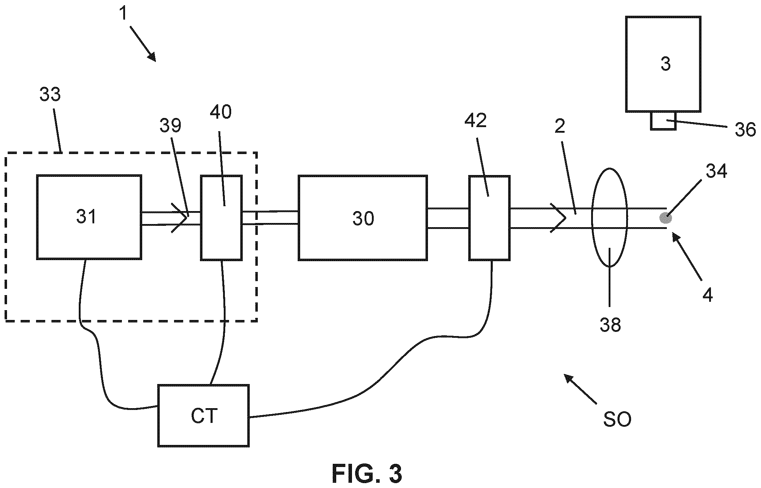

Figure 3 schematically depicts a radiation source SO according to an embodiment of the invention. The radiation source SO comprises a fuel generator 3 configured to direct tin droplets to a plasma formation region 4. A tin droplet 34 is depicted at the plasma formation region 4. The fuel generator 3 includes a nozzle 36 from which tin droplets are ejected. The diameter of the tin droplets is determined by the diameter of the nozzle 36. The nozzle includes an actuator (not depicted) which modulates the nozzle 36. The modulation frequency applied to the actuator determines the repetition rate at which tin droplets are ejected from the nozzle 36. Liquid tin is held under pressure in the fuel generator 3. The pressure at which the liquid tin is held determines the velocity of tin droplets ejected from the nozzle 36.

Figure 3 also depicts a laser system 1 of the radiation source SO. The laser system 1 comprises a laser 30, a seed laser system 33, electro-optic modulators 40, 42, focussing optics 38, and a controller CT. The laser system 1 may include other elements. The electro-optic modulators 40, 42 may be omitted in some embodiments. In other embodiments one or more electro-optic modulators may be provided at other locations.

The laser 30 may for example be a Tm:YLF laser. The laser 30 is configured to provide a laser beam 2. The laser beam 2 comprises laser pulses which are incident upon tin droplets 34 (one tin droplet is schematically depicted). The laser beam 2 has a wavelength between 1.6 microns and 2.5 microns (e.g. 1.9 microns). The wavelength of the laser beam 2 may be referred to as 2 microns for brevity. One pulse of laser radiation is incident upon each tin droplet. The laser 30 may comprise a gain medium (e.g. Tm:YLF) which is pumped by an optical pump (which may for example comprise one or more solid state lasers or LEDs, or one or more optical fiber lasers). The laser 30 may be electrically pumped. Other examples of lasers that may be used are Tm:YAG and Ho:YAG.

The seed laser system 33 in this embodiment comprises a seed laser 31 and an electro-optic modulator 40. The seed laser 31 may for example be an electrically pumped laser diode. The seed laser may for example be an optically pumped crystal located between mirrors which define a laser cavity. The seed laser may be a mode locked oscillator in use. Any suitable pulsed laser may be used as the seed laser. The seed laser 31 provides a pulsed seed laser beam 39 which is coupled into the laser 30. The seed laser beam 39 may have a wavelength of 790 nm (or some other wavelength).

In use, the gain medium of the laser 30 is pumped to provide a population inversion. The seed laser 31 provides a seed laser pulse which enters a gain medium of the laser 30 and causes the laser 30 to emit a laser beam 2. The laser beam 2 is pulsed, with a repetition rate of pulses of the laser beam corresponding with the repetition rate of pulses of the seed laser beam 39 (although the duration of the laser pulses may differ from the duration of the seed laser pulses). In some embodiments the laser 30 may be considered to be a laser amplifier.

The optics 38 may comprise one or more focussing elements (e.g. one or more lenses). The optics 38 may form a waist of the laser beam 2 at or adjacent to the plasma formation region 4. The optics 38 (and/or other optics) may be referred to as optics of the radiation source. The optics may include one or more mirrors comprising a vapour chamber in accordance with the present disclosure.

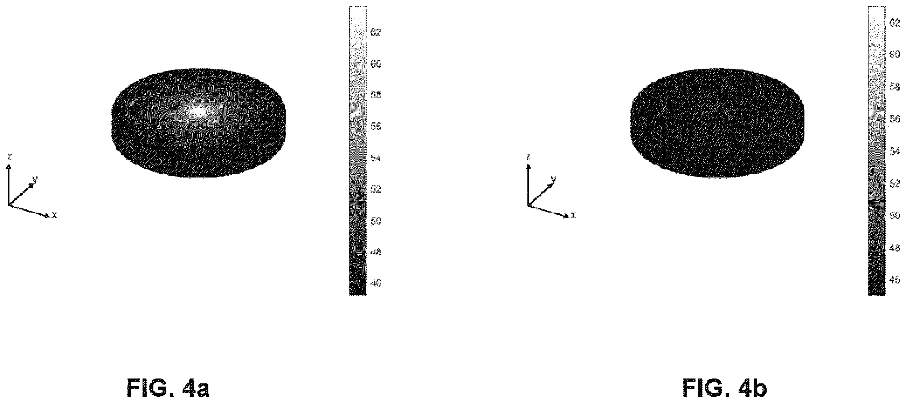

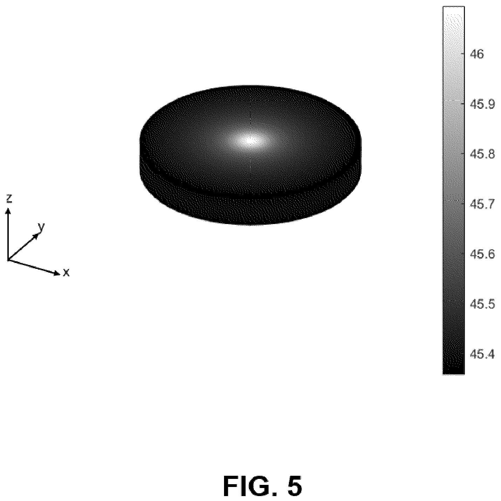

Figures 4a and 4b are comparative examples of a circular disc having a diameter of 100 mm and a thickness of 30 mm and illuminated with a Gaussian beam size of 35.5 mm. In a simulated heat load of 300 W, the circular disc, which replicates an optical element as described herein, heats up. Figure 4a depicts a disc which does not have a vapour chamber and so a hot spot is observed in the centre of the disc and the temperature of the disc decreases radially outwardly. The arrows in Figures 4a and 4b indicate the approximate temperatures of the different portions of the discs according to the scale. Figure 4b depicts a circular disc including a vapour chamber. As can be seen, using the same temperature scale as Figure 4a, there is almost no temperature differential across the disc. Figure 5a uses a much narrower temperature scale. Again, it can be seen that the centre of the disc has the highest temperature, with the temperature decreasing radially outwardly. However, there is only around a 0.7 K temperature difference across the disc, as opposed to a temperature difference of 16 K or more across the disc which does not include a vapour chamber. This allows for the provision of cheaper mirrors which do not need direct cooling. This also reduces warping or deformation since the temperature of the optical element is more uniform. In addition, this also allows a common feed of conditioning fluid to be provided to mirrors which would otherwise have been directly cooled mirrors and to mirrors which rely on indirect cooling. This eliminates the need for additional pipework, control systems, and separate coolers, and thereby makes manufacturing and maintenance cheaper.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

In summary, the present disclosure allows for the provision of radiation sources which are simpler and cheaper to manufacture. Expensive directly cooled mirrors can be dispensed with and replaced by mirrors including a vapour chamber which operates like a heat pipe. This also allows the optical elements comprising a vapour chamber to be connected to the same conditioning fluid line as any indirectly cooled mirrors within the apparatus, thereby eliminating a separate conditioning system which is required when there are both directly and indirectly cooled mirrors within a system. This further simplifies the system and makes construction and maintenance cheaper and simpler. The vapour chamber not only allows for more rapid heat transfer of thermal energy to a heat sink, it also allows for more efficient spreading of heat across the optical element.

## Claims

1. A radiation source comprising a laser system, wherein the laser system is arranged to transport a laser beam from a source to a target region along a beam path, the beam path including at least one optical element in thermal communication with a vapour chamber arranged to distribute thermal energy provided by the laser beam and to cool the optical element in combination with a heat sink.

2. The radiation source according to claim 1, wherein the optical element comprises a reflective surface configured to reflect incident laser light and the reflective surface comprises a wall of the vapour chamber.

3. The radiation source according to claim 2, wherein the reflective surface is a copper reflective surface or a coated surface configured to reflect incident carbon dioxide laser light.

4. The radiation source according to any preceding claim, wherein the heat sink is an actively or passively cooled heat sink.

5. The radiation source according to any preceding claim, wherein the optical element is directly or indirectly cooled.

6. The radiation source according to any preceding claim, wherein the laser system is a carbon dioxide laser system.

7. The radiation source according any preceding claim, wherein the radiation source includes at least two optical elements, wherein a first optical element is a beam transport system mirror or a final focus assembly mirror, and a second optical element is a high power drive laser mirror, and wherein the first and second optical elements are cooled by respective heat sinks in thermal communication with a common conditioning fluid.

8. The radiation source according to claim 7, wherein the common conditioning fluid comprises water.

9. The radiation source according to any preceding claim, wherein the optical element is a mirror or an aperture.

10. An EUV utilization apparatus including the radiation source according to any of claims 1 to 9.

11. The EUV utilization apparatus according to claim 10, wherein the EUV utilization apparatus is a lithographic apparatus, an inspection apparatus, or a metrology apparatus.

12. A method of operating a radiation source, the method including:
i) generating a laser beam;
ii) illuminating an optical element with the laser beam, the optical element configured to reflect the laser beam;
iii) providing a vapour chamber comprising a first face configured to reflect the laser beam and a second face configured to cool vapour within the chamber;
iv) providing a conditioning fluid to the vapour chamber to condition vapour therein and consequently condition the optical element.

13. The method according to claim 12, wherein the method includes providing the conditioning fluid to the vapour chamber and to another optical element.

14. The use of the radiation source according to any of claims 1 to 9, the EUV utilization apparatus according to claim 10 or 11, or the method according to claim 12 or 13 in an EUV utilisation method or apparatus.

15. The use according to claim 14, wherein the EUV utilization method or apparatus is a lithographic apparatus or method, an inspection apparatus or method, or a metrology apparatus or method.
